# EUROPÄISCHE PATENTSCHRIFT

(11) **EP 1 269 805 B1**
(45) Veröffentlichungstag und Bekanntmachung des Hinweises auf die Patenterteilung: **12.07.2006**
(21) Anmeldenummer: 01915069.7
(22) Anmeldetag: 01.03.2001
(51) Int. Cl.: H05K 1/11

(54) **ELEKTRISCHE SCHALTUNG UND SUBSTRAT HIERZU**
ELECTRICAL CIRCUIT AND SUBSTRATE THEREFOR
CIRCUIT ELECTRIQUE ET SUBSTRAT APPROPRIE

(30) Priorität: 07.03.2000 DE 10010979
(43) Veröffentlichungstag der Anmeldung: 02.01.2003
(73) Patentinhaber: ROBERT BOSCH GMBH, 70442 Stuttgart (DE)
(72) Erfinder: HOEBEL, Albert-Andreas, 72760 Reutlingen (DE); HEIDER, Frank, 72760 Reutlingen (DE); RAUTZENBERG, Bernd, 31079 Sibbesse (DE); RAICA, Thomas, D-72379 Hechingen (DE); HAUGENEDER, Andreas, 72766 Reutlingen (DE)
(86) Internationale Anmeldenummer: PCT/DE2001/000766
(87) Internationale Veröffentlichungsnummer: WO 2001/067832

(56) Entgegenhaltungen:
- EP-A- 0 971 569
- FR-A- 2 156 315
- US-A- 4 793 543
- US-A- 5 291 375
- US-A- 5 872 399

## Beschreibung

### Stand der Technik

Die Erfindung geht aus von einer elektrischen Schaltung auf einem Substrat beziehungsweise von einem Substrat nach der Gattung der unabhängigen Ansprüche. Es ist bekannt, Bauelemente beispielsweise auf einer Leiterplatte per Lötmontage zu befestigen. Die Bauelemente müssen an bestimmten Orten befestigt sein, um ein Bonden sowie eine elektrische Prüfung zu ermöglichen und um Kurzschlüsse zu vermeiden und eine dichte Schaltungspackung zu gewährleisten. Zur Begrenzung des Bereichs, in dem sich das Lot bei der Montage ausbreiten kann, ist es bekannt, auf das Substrat beziehungsweise die Leiterbahn Lötstoplack aufzutragen oder sich über die Oberfläche des Substrats erhebende Begrenzungsmaterialien (sogenannte Lötschablonen) vor dem Löten auf dem Substrat zu befestigen.

### Vorteile der Erfindung

Die erfindungsgemäße Schaltung beziehungsweise das erfindungsgemäße Substrat mit den kennzeichnenden Merkmalen der unabhängigen Ansprüche haben demgegenüber den Vorteil, daß zur definierten Plazierung von Bauelementen, das heißt zum Unterbinden eines "Wegschwimmens" beziehungsweise zum Vermindern des Verkippens des Bauelements während der Montage, eine Lötstopstruktur ohne zusätzliche Prozeßschritte realisiert werden kann. Die Vertiefungen können zusammen mit der Strukturierung der Leiterbahnen in einem Schritt hergestellt werden. Darüber hinaus lassen die Vertiefungen die Eigenschaften des Substrats im Gegensatz zum Einsatz einer verlorenen Lötschablone unbeeinflußt. Die als Löcher oder Gräben ausgebildeten Vertiefungen tragen auch zu einer Stabilisierung der mechanischen Verbindung beispielsweise zwischen der metallischen Leiterbahnschicht und dem keramischen Substrat bei, welches zwei Materialien mit stark unterschiedlichen Ausdehnungskoeffizienten sind.

Durch die in den abhängigen Ansprüchen und in der Beschreibung aufgeführten Maßnahmen sind vorteilhafte Weiterbildungen und Verbesserungen der in den unabhängigen Ansprüchen angegebenen Vorrichtungen möglich.

### Zeichnung

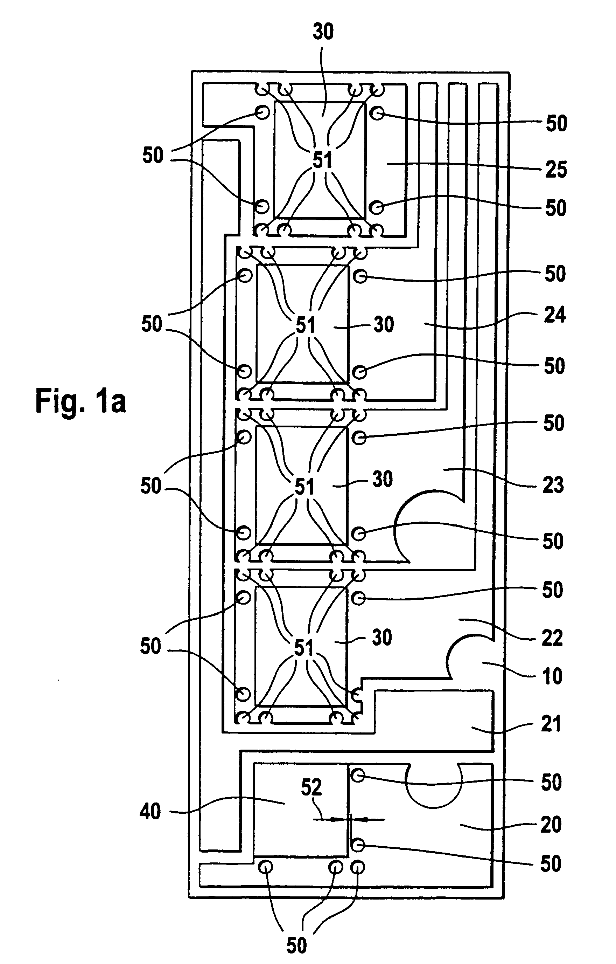

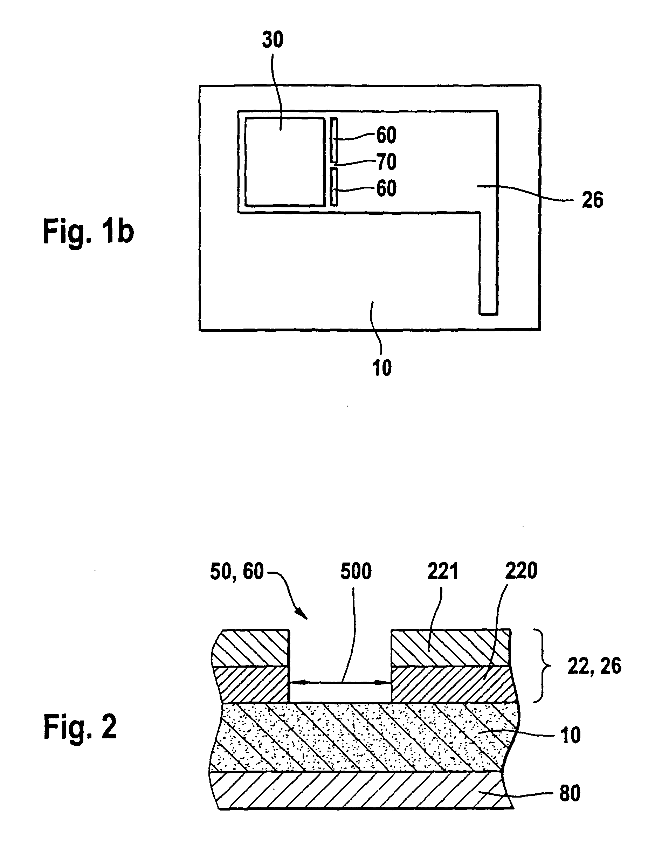

Ausführungsbeispiele der Erfindung sind in der Zeichnung dargestellt und in der nachfolgenden Beschreibung näher erläutert. Figur 1a zeigt eine Schaltung mit Leiterbahnschichten, die Löcher aufweisen. Figur 1b zeigt eine Schaltung mit einer Leiterbahnschicht, die längliche Vertiefungen (Gräben) aufweist. Figur 2 zeigt eine Querschnittsseitenansicht.

### Beschreibung der Ausführungsbeispiele

Figur la zeigt eine Leiterplatte 10 mit auf der Oberfläche des Substrates angeordneten Leiterbahnschichten 20, 21, 22, 23, 24 und 25. Auf den Leiterbahnschichten sind Bauelemente 30 beziehungsweise 40 aufgebracht, zum Beispiel Leistungsbausteine, Transistorchips oder Diodenchips. Diese Bauelemente stehen mit ihrer Unterseite mit der jeweiligen Leiterbahnschicht über eine Lotverbindung in elektrischem Kontakt. Die Bauelemente sind an ihren Ecken von Löchern (engl. "Dimples") 50 beziehungsweise 51 in der jeweiligen Leiterbahnschicht umgeben. Das Bezugszeichen 51 markiert hierbei sogenannte randständige Löcher, das heisst Löcher, die keine vollständige kreisförmige Ausformung aufweisen, da der Abstand ihres Zentrums vom Rand der Leiterbahnschicht kleiner als ihr Radius ist. Der Abstand 52 des Randes eines Bauelements von den Lochrändern beträgt hier 200 Mikrometer. Figur 1b zeigt eine Leiterplatte 10 mit einer Leiterbahnschicht 26 analog zur Figur la. Das Bauelement 30 ist auf einer Seite von zwei Gräben 60 in der Leiterbahnschicht benachbart. Der Abstand der Gräben vom Bauelement 30 entspricht ungefähr dem in Figur la illustrierten Abstand 52. Die zwei Gräben 60 sind durch einen Verbindungssteg 70 voneinander getrennt.

Die Löcher beziehungsweise die Gräben dienen bei der Lötmontage zur Positionsdefinition von Bauelementen auf der Leiterplatte (allgemeiner dem Substrat). Wird Lot auf die Schicht aufgebracht, auf der ein Bauelement befestigt werden soll, so stellen die Löcher/Gräben eine Barriere (schlecht benetzbarer Bereich) für das Lot dar, über die das Bauelement nicht hinausschwimmen kann. Das liegt an den Rückstellkräften, die für das Lot und das darauf "schwimmende" Bauelement auftreten, sobald das Bauelement bei der Montage durch "Wegschwimmen" an die Begrenzung herankommt. Dadurch wird eine definierte Bauelementplazierung gewährleistet. Diese Rückstellkräfte haben ihren Ursprung in der niedrigeren Benetzungsfähigkeit der Leiterplatte am Loch- bzw. Grabenboden im Vergleich zur Leiterbahnschicht und der Oberflächenspannung des Lotes. Ein an die Begrenzungsstruktur "heranschwimmendes" Bauelement wird an seiner Unterseite weiterhin vom Lot benetzt, während das Lot auf der Leiterplatte die als Lotbarriere wirkende Loch- bzw. Grabenstruktur nicht überwinden kann. - Die Leiterbahnschichten zwischen den Löchern beziehungsweise Gräben leiten den elektrischen Strom zur Lotkontaktierung des Bauelements und dienen gleichzeitig zur Wärmeableitung vom Bauelement. Je nach erforderlicher Stromtragfähigkeit und Wärmeleitfähigkeit der Leiterbahnschicht können Gräben oder Löcher unterschiedlicher Länge beziehungsweise Zahl verwendet werden, um die Platzierung der Bauelemente zu unterstützen. Der Abstand vom Rand des Bauelements zum Loch- bzw. Grabenrand sollte einen gewissen Mindestabstand, beispielsweise 200 Mikrometer, nicht unterschreiten, um im Rahmen der gegebenen Montagetoleranz, die unter anderem durch den verwendeten Bestückungsautomaten gegeben ist, der die Bauelemente auf die Leiterplatte aufsetzt, die Begrenzungsstruktur (Löcher bzw. Gräben) bei der Anwendung eines Reflow-Verfahrens nach dem Umschmelzen nur teilweise mit Lot zu füllen. Je größer der Abstand gewählt wird, umso schlechter ist die durch die Begrenzungsstruktur erzielte Positioniergenauigkeit.

Alternativ kann die Leiterplatte ein DBC (Direct bonded copper)-Substrat sein oder aus anderen Substratmaterialien, beispielsweise IMS (insulated metal substrate) bestehen. Die Löcher 50, 51 können auch entlang der Seitenränder und nicht nur an den Ecken angeordnet werden, wobei der Effekt der Positionsdefinition durch die eckständigen Lochstrukturen bereits gewährleistet ist und die Ausfüllung der Seitenbereiche mit Löchern lediglich einer Erhöhung der Rückstellkraft dient. Die Gräben 60 können ebenso auf allen oder zumindest mehreren Seiten des Bauelements vorgesehen sein, alternativ können Verbindungsstege 70 auch teilweise entfallen. Begrenzt ist die Abgrenzung der unter dem Bauelement liegenden Metallschicht vom Rest der Leiterbahnschicht durch den maximal zu tragenden Strom, der über die Bereiche zwischen den Löchern beziehungsweise zwischen den Gräben fließen muß. Es sind auch umgekehrt mehrere Verbindungsstege 70 pro Seite des Bauelements wählbar, so daß letztlich Übergangsformen bis hin zu einer Anreihung von Löchern 50,51 auf jeder Seite realisierbar sind.

Figur 2 stellt eine Querschnittsseitenansicht eines Teils eines DBC-Substrates 10 gemäß Figur 1 dar. Die Rückseite des Substrates ist mit einer Kupferschicht 80 versehen. Auf der Vorderseite ist die Leiterbahnschicht 22 (Figur la) beziehungsweise 26 (Figur 1b) in der Umgebung eines Lochs 50 beziehungsweise eines Grabens 60 abgebildet. Das Loch 50 (der Graben 60) hat einen Durchmesser 500 (eine Ausdehnung senkrecht zum Rand des Bauelements) größer als 400 Mikrometer, vorzugsweise 800 Mikrometer (bedingt durch den Ätzprozeß). Die Leiterbahnschicht besteht aus einer ersten Metallschicht 220 aus Kupfer, die direkt auf das Substrat aufgebracht ist; die Rückseitenmetallisierung ist aus dem gleichen Metall hergestellt. Die zweite auf der ersten Metallschicht aufgebrachte Schicht 221 ist eine Schichtung aus Gold und Nickel, wobei die Nickelteilschicht auf dem Kupfer und die Goldteilschicht auf der Nickelteilschicht aufgebracht ist. Die Rückseitenmetallisierung hat eine Schichtdicke von typischerweise 300 Mikrometern, die beispielsweise aus Keramik bestehende elektrische Isolationsschicht 10 eine Dicke von 600 Mikrometern, die erste Metallschicht 220 (Kupferschicht) eine Dicke von zirka 300 Mikrometern, die Nickelteilschicht eine Dicke von zirka 20 bis 70 Mikrometern und die Goldteilschicht eine Dicke von zirka 0,02 - 0,1 Mikrometern.

Die Löcher 50, 51 beziehungsweise Gräben 60 werden zusammen mit den Leiterbahnschichten auf dem Susbtrat strukturiert. Die schlechtere Benetzungsfähigkeit des Lots in der Begrenzungsstruktur als auf den Leiterbahnschichten rührt daher, daß der Boden der Begrenzungsstruktur aus nicht benetzbarem Substratmaterial (beispielsweise Keramik) besteht, so daß das Lot zwar die Wandung der Begrenzungsstruktur noch benetzen kann, aber aufgrund des dazwischenliegenden Bodens nicht die Struktur vollends füllt. In einer alternativen Ausführungsform können auch Teile der Seitenwandungen der Löcher beziehungsweise Gräben aus Substrat- bzw. Leiterplattenmaterial bestehen. Dann muß allerdings in einem separaten Arbeitsgang die Begrenzungsstruktur durch Materialabtrag eingebracht werden, wobei dieser Materialabtrag dann zumindest teilweise auch das Substrat 10 erfaßt. Zusätzlich können die Leiterbahnwände der Begrenzungsstruktur noch selektiv oxidiert werden, wodurch sie schlecht benetzen. In einer solchen Ausführungsform, bei der auch die Wände oder zumindest auch ein Teil der Wandflächen der Begrenzungsstruktur nicht benetzt werden, kann aufgrund der somit erhöhten Barrierenwirkung der Durchmesser der Löcher auch kleiner als 400 Mikrometer gewählt werden.

## Patentansprüche

1. Elektrische Schaltung auf einem Substrat (10) mit mindestens einem auf einer Leiterbahnschicht (20; 21; 22; 23; 24; 25) befestigten Bauelement(30; 40), wobei das Bauelement von Vertiefungen (50; 51; 60) in der Leiterbahnschicht umgeben ist, **dadurch gekennzeichnet, dass** die Seitenwände der Vertiefungen teilweise vom Substrat gebildet sind.

2. Elektrische Schaltung nach Anspruch 1, **dadurch gekennzeichnet, dass** das Bauelement auf der Leiterbahnschicht angelötet oder aufgeklebt ist.

3. Elektrische Schaltung nach einem der vorhergehenden Ansprüche, **dadurch gekennzeichnet, dass** die Vertiefungen in Form von insbesondere kreisrunden Löchern oder in Form von Gräben ausgebildet sind.

4. Elektrische Schaltung nach einem der vorhergehenden Ansprüche, **dadurch gekennzeichnet, dass** der Boden der Vertiefungen durch das Substrat gebildet ist.

5. Elektrische Schaltung nach einem der vorhergehenden Ansprüche, **dadurch gekennzeichnet, dass** das Substrat eine Leiterplatte oder eine Keramikplatte ist.

6. Elektrische Schaltung nach einem der vorhergehenden Ansprüche, **dadurch gekennzeichnet, dass** die Leiterbahnschicht aus einer Kupferschicht, einer Nickel- und einer Goldschicht besteht, wobei die Kupferschicht auf dem Substrat, die Nickelschicht auf der Kupferschicht und die Goldschicht auf der Kupferschicht aufgebracht ist.

7. Substrat mit mindestens einer Leiterbahnschicht zur Befestigung mindestens eines elektrischen Bauelements, **dadurch gekennzeichnet, dass** die Leiterbahnschicht Vertiefungen aufweist zur Bereitstellung einer Fließbarriere für ein Verbindungsmaterial, das zur Befestigung des Bauelements dient, wobei die Vertiefungen eine Fläche zur Befestigung des Bauelements umgeben und in einem solchen Abstand voneinander angeordnet sind, dass zwischen ihnen das Bauelement Platz hat, ohne dass durch das Bauelement die Vertiefungen verdeckt werden müssen, wobei der Boden der Vertiefungen durch das Substrat gebildet ist.

8. Substrat nach Anspruch 7, **dadurch gekennzeichnet, dass** die Vertiefungen in Form von insbesondere kreisrunden Löchern oder in Form von Gräben ausgebildet sind.

9. Substrat nach Anspruch 7 oder 8, **dadurch gekennzeichnet, dass** die Seitenwände der Vertiefungen teilweise vom Substrat gebildet sind.

10. Substrat nach einem der Ansprüche 7 bis 9, **dadurch gekennzeichnet, dass** die Leiterbahnschicht aus einer Kupferschicht, einer Nickel- und einer Goldschicht besteht, wobei die Kupferschicht auf dem Substrat, die Nickelschicht auf der Kupferschicht und die Goldschicht auf der Kupferschicht aufgebracht ist.

## Claims

1. Electrical circuit on a substrate (10) having at least one component (30; 40) that is fixed to an conductor track layer (20; 21; 22; 23; 24; 25), the component being surrounded by depressions (50; 51; 60) in the conductor track layer, **characterized in that** the side walls of the depressions are partially formed by the substrate.

2. Electrical circuit according to Claim 1, **characterized in that** the component is soldered to or adhesively bonded to the conductor track layer.

3. Electrical circuit according to one of the preceding claims, **characterized in that** the depressions are in the form of, in particular, circular holes or are in the form of trenches.

4. Electrical circuit according to one of the preceding claims, **characterized in that** the bottom of the depressions is formed by the substrate.

5. Electrical circuit according to one of the preceding claims, **characterized in that** the substrate is a printed circuit board or a ceramic plate.

6. Electrical circuit according to one of the preceding claims, **characterized in that** the conductor track layer comprises a copper layer, a nickel layer and a gold layer, the copper layer being applied to the substrate, the nickel layer being applied to the copper layer and the gold layer being applied to the copper layer.

7. Substrate having at least one conductor track layer for fixing at least one electrical component, **characterized in that** the conductor track layer has depressions for providing a flow barrier for a connecting material that is used to fix the component, the depressions surrounding an area for fixing the component and being arranged at such a distance from one another that the component has space between them without the depressions having to be covered by the component, the bottom of the depressions being formed by the substrate.

8. Substrate according to Claim 7, **characterized in that** the depressions are in the form of, in particular, circular holes or are in the form of trenches.

9. Substrate according to Claim 7 or 8, **characterized in that** the side walls of the depressions are partially formed by the substrate.

10. Substrate according to one of Claims 7 to 9, **characterized in that** the conductor track layer comprises a copper layer, a nickel layer and a gold layer, the copper layer being applied to the substrate, the nickel layer being applied to the copper layer and the gold layer being applied to the copper layer.

## Revendications

1. Circuit électrique sur un substrat (10) comportant au moins un composant (30 ; 40) fixé sur une couche de piste conductrice (20 ; 21 ; 22 ; 23 ; 24 ; 25), le composant étant entouré d'évidements (50 ; 51 ; 60) dans la couche de piste conductrice,
**caractérisé en ce que**
les parois latérales des évidements sont partiellement formées par le substrat.

2. Circuit électrique selon la revendication 1,
**caractérisé en ce que**
le composant est brasé ou collé sur la couche de piste conductrice.

3. Circuit électrique selon l'une des revendications précédentes,
**caractérisé en ce que**
les évidements sont réalisés en particulier, sous la forme, de trous circulaires ou de fosses.

4. Circuit électrique selon l'une des revendications précédentes,
**caractérisé en ce que**
le fond des évidements est formé par le substrat.

5. Circuit électrique selon l'une des revendications précédentes,
**caractérisé en ce que**
le substrat est une plaquette de circuit imprimé ou une plaque de céramique.

6. Circuit électrique selon l'une des revendications précédentes,
**caractérisé en ce que**
la couche de piste conductrice se compose d'une couche de cuivre, d'une couche de nickel et d'une couche d'or, la couche de cuivre étant appliquée sur le substrat, la couche de nickel sur la couche de cuivre et la couche d'or sur la couche de cuivre.

7. Substrat comportant au moins une couche de piste conductrice permettant de fixer au moins un composant électrique,
**caractérisé en ce que**
la couche de piste conductrice présente des évidements permettant l'obtention d'une barrière d'écoulement pour un matériau de liaison qui sert à fixer le composant, les évidements entourant une surface pour fixer le composant et étant agencés à une telle distance les uns des autres que le composant trouve de la place entre eux, sans qu'il soit nécessaire que les évidements soient couverts par le composant, le fond des évidements étant formé par le substrat.

8. Substrat selon la revendication 7,
**caractérisé en ce que**
les évidements sont réalisés, en particulier, sous la forme de trous circulaires ou de fosses.

9. Substrat selon la revendication 7 ou 8,
**caractérisé en ce que**
les parois latérales des évidements sont partiellement formées par le substrat.

10. Substrat selon l'une des revendications 7 à 9,
**caractérisé en ce que**
la couche de piste conductrice se compose d'une couche de cuivre, d'une couche de nickel et d'une couche d'or, la couche de cuivre étant appliquée sur le substrat, la couche de nickel sur la couche de cuivre et la couche d'or sur la couche de cuivre.
